(19) Europäisches Patentamt
European Patent Office
Office européen des brevets

(11) **EP 4 682 548 A1**

(12) **EUROPEAN PATENT APPLICATION**

(43) Date of publication:
**21.01.2026 Bulletin 2026/04**

(21) Application number: **25183224.2**

(22) Date of filing: **17.06.2025**

(51) International Patent Classification (IPC):
**G01R 15/16** $^{(2006.01)}$    **G01R 27/26** $^{(2006.01)}$
**G01R 35/00** $^{(2006.01)}$    **G01B 7/06** $^{(2006.01)}$
**G01B 7/12** $^{(2006.01)}$

(52) Cooperative Patent Classification (CPC):
**G01R 15/16; G01B 7/08; G01B 7/12;
G01R 27/2605; G01R 35/005**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: **17.06.2024 US 202463660935 P
16.06.2025 US 202519239566**

(71) Applicant: **Analog Devices International
Unlimited Company
Co. Limerick (IE)**

(72) Inventor: **Hurwitz, Jonathan Ephraim David
Limerick (IE)**

(74) Representative: **Horler, Philip John
Withers & Rogers LLP
2 London Bridge
London SE1 9RA (GB)**

(54) **WIRE GAUGE DETERMINATION**

(57) The present disclosure relates to determination of gauge of a conductive wire. The gauge is determined by determining capacitive coupling between the conductive wire and a conductive sense component that is positioned in non-contacting proximity with the conductive wire. The gauge of the conductive wire is then determined based on the determined capacitive coupling.

Fig. 5

# Description

This application claims priority from US provisional patent application number 63/660,935 filed on 17 June 2025, which is incorporated herein by reference in its entirety.

## Technical field

The present disclosure relates to methods, circuits and systems for determining the gauge/thickness of an electrical wire.

## Background

The gauge (also referred to interchangeably as thickness and diameter) of electrical wire is a significant factor in the wire's current handling capability. Typically, electrical wires will have a maximum recommended current, which is dependent, at least in part, on the gauge of the wire. Generally, relatively low gauge wires will only be able to carry relatively low current safely and efficiently, and relatively large gauge wires will be able to carry relatively large currents safely and efficiently. If a relatively low gauge wire carries a current that exceeds its recommended current, the wire may be overloaded, which may cause a fire and/or excessive power loss in the wire.

Normally, installers of electrical systems will use the correct gauge wire for the expected maximum currents of the system. However, there are times when this may not be the case. Larger gauge wires tend to be more expensive, so some installers may deliberately install smaller gauge wires in order to save costs. In other instances, the incorrect gauge of wire may be installed as a result of human error, or because the correct gauge of wire was not readily available. In other instances, in multi-conductor systems, such as remote power panels (RPPs) or power distribution units (PDUs), different gauges may be required for different conductors, and all of the correct wires may be installed but then incorrectly connected by the installer. As a result, some wires may end up carrying currents that exceed their rated maximum.

Consequently, determining the gauge of conductive wires may be very helpful for safety and efficiency purposes, to confirm that the correct gauge of wire has been used. Physically inspecting and measuring the conductors may in some situations be difficult, for example because access is difficult, and/or because the insulative coating of the wire carries no indication of the gauge and a physical measurement of the outer diameter does not reveal the gauge of the conductor within, since the thickness of the insulative coating is unknown. Invasive techniques such as insulation striping or wire cutting are problematic from a safety perspective, particularly for live systems. Therefore, new techniques for efficiently determining the gauge of an electrical wire are desirable.

## Summary

In a first aspect of the disclosure, there is provided a wire gauge determination system comprising: a conductive sense component for positioning, when in use, in non-contacting proximity to a conductive wire so as to capacitively couple with the conductive wire to generate an AC sensing signal at the conductive sense component, wherein the AC sensing signal is dependent on an AC voltage of the conductive wire; a determination circuit coupled to the conductive sense component and configured to: determine a capacitive coupling between the conductive wire and the conductive sense component; and determine a gauge of the conductive wire based on the determined capacitive coupling between the conductive wire and the conductive sense component.

In a second aspect of the disclosure, there is provided a method for determining wire gauge, the method comprising: determining a capacitive coupling between a conductive wire and a conductive sense component, wherein the conductive sense component is positioned in non-contacting proximity to the conductive wire so as to capacitively couple with the conductive wire to generate an AC sensing signal at the conductive sense component, wherein the AC sensing signal is dependent on an AC voltage of the conductive wire; and determining a gauge of the conductive wire based on the determined capacitive coupling between the conductive wire and the conductive sense component.

In a third aspect of the disclosure, there is provided an electrical system comprising: a conductive wire for carrying an electrical current; a conductive sense component positioned in non-contacting proximity to the conductive wire so as to capacitively couple with the conductive wire to generate an AC sensing signal at the conductive sense component, wherein the AC sensing signal is dependent on an AC voltage of the conductive wire; a determination circuit coupled to the conductive sense component and configured to: determine a capacitive coupling between the conductive wire and the conductive sense component; and determine a gauge of the conductive wire based on the determined capacitive coupling between the conductive wire and the conductive sense component.

## Drawings

Aspects of the present disclosure are described, by way of example only, with reference to the following drawings, in which:

Figure 1 shows an example poly-phase energy measurement system;
Figure 2A shows an example top-down view of a conductive sense component and PCB with a central opening through which a conductor passes;
Figure 2B shows a side-on view of the arrangement of Figure 2A;
Figure 3A shows a further example top-down view of a conductive sense component and PCB with a central opening through which a conductor passes;
Figure 3B shows a side-on view of the arrangement of Figure 3A;
Figure 4 shows an example wire gauge determination system;
Figure 5 shows example details of the wire gauge determination system of Figure 4;
Figures 6A and 6B show an example representation of the capacitive coupling between the conductive sense component and conductor of Figure 2A;
Figures 7A and 7B show an example representation of the capacitive coupling between the conductive sense component and conductor of Figure 3A;
Figure 8 shows a further example wire gauge determination system;
Figure 9 shows a further example wire gauge determination system;
Figure 10 shows a further example wire gauge determination system;
Figure 11 shows a further example wire gauge determination system;
Figure 12 shows a further example wire gauge determination system; and
Figure 13 shows an example method for wire gauge determination.

## Detailed Description

The inventors have developed systems, circuits and methods for contactless wire gauge determination, utilising non-contact voltage sensing techniques. There are many reasons why it may be desirable to determine the gauge of an installed wire, such as confirmation of correct installation, detection of system power inefficiencies, detection of safety risks in the system, etc. However, physical measurement and invasive inspection can be problematic.

In a non-contact voltage sensing system, there is no direct electrical connection (i.e., no galvanic contact) between the conductor carrying the signal being sensed and the circuitry performing the sensing. Instead of a galvanic contact, a conductive sense component may be positioned in non-contacting proximity to the conductor carrying the signal to be sensed (eg, positioned on, or near, an insulator that encases the conductor carrying the signal to be sensed), to form a capacitive coupling with the conductor carrying the signal to be sensed. Any changes in the signal being carried by the conductor should induce a signal in the conductive sense component, as a result of the capacitive coupling, which can then be sensed by circuitry connected to the conductive sense component.

The inventors have developed a wire gauge determination technique that utilises non-contact voltage sensing. By utilising non-contact techniques, it is possible to implement wire gauge determination more easily and at lower cost compared with invasive techniques.

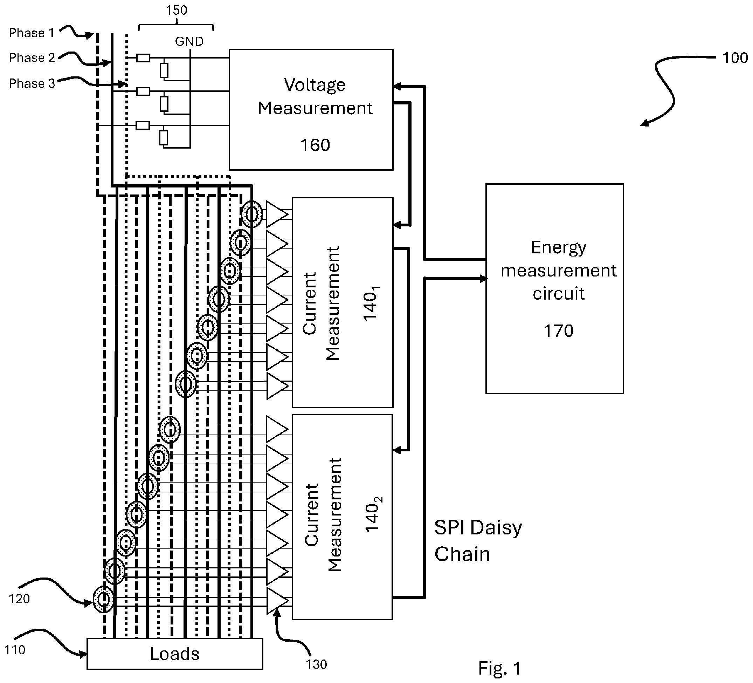

Figure 1 shows an example poly-phase energy measurement system 100. The system 100 comprises a three phase voltage supply - phase 1, phase 2 and phase 3 - from each of which are multiple branches each potentially serving at least one load within the loads 110. There are various uses of such systems, for example for metering in Electric Vehicle Supply Equipment (EVSE) or motor drive, or for power distribution units (PDUs), etc.

For each branch there is a current transducer, for example a current transformer or a rate of change of current sensor (di/dt current sensor) such as a Rogowski coil. In this example, the current transducers are non-contact current sensors, which has the benefit of more straightforward installation on each of the branches and may reduce cost/complexity if the voltages on each branch are likely to be high enough to require isolation mechanisms between a galvanic contact and the current measurement circuitry. However, the current transducers 120 could alternatively be of any other type, such as shunts.

The system 100 also comprises an optional buffer 130 for the current measurement signal derived from each current transducer 120, and current measurement circuitry $140_1$ and $140_2$, for generating a measurement of current. In this particular implementation, the current measurement circuitry is divided across two dies/chips, but in an alternative, it may be implemented in a single die/chip, or divided across three or more dies/chips. Also in this particular implementation, the current measurement circuitry $140_1$ and $140_2$ is connected together, and to the energy measurement unit 170, with SPI daisy chaining, but any alternative communication coupling may be used. The current measurement circuitry $140_1$ and $140_2$ is configured to output digital signals to the energy measurement unit 170, indicative of each current measurement.

The system 100 also comprises circuitry for measuring each phase voltage. In this example, the circuitry comprises optional potential dividers 150 arranged to form a galvanic connection to each phase, and divide the voltage down. The circuitry also comprises a voltage measurement circuit 160 configured to measure the divided down voltage and output digital signals to the energy measurement unit 170 (via the SPI daisy chaining, in this particular example) indicative of the measured voltages. The voltage measurement circuit 160 may comprise isolation functionality to isolate the relatively high voltage, hot side, which is coupled to the potential dividers 150, from the relatively low voltage digital interface. Such circuitry may be practical for measuring voltages of the three phase supply, but not practical or cost efficient for measuring voltage of all the branches from each phase, particularly where there are a very large number of branches from each phase.

The energy measurement unit 170 may comprise any suitable functionality for energy measurement/metrology using the received voltage and current measurement digital signals and/or for controlling the current measurement circuits $140_1$ and $140_2$ and the voltage measurement circuit 160.

Whilst this system 100 is configured for energy measurement, it will be appreciated that this is an optional function of the system 100 and it may have any additional or alternative functionality. Furthermore, this particular type of system 100 is just one example context in which the wire gauge determination techniques disclosed herein may be useful. The disclosed wire gauge determination techniques may also be useful in any other type of electrical system, including single phase, two phase, three phase, etc systems, with one or multiple conductive wires whose gauge is to be determined.

The inventors have recognised that in arrangements where there is already a current transducer in place, particularly a PCB implemented current transducer such as a PCB implemented Rogowski coil, non-contact voltage sensing capabilities may be added relatively easily.

As the skilled person will understand, a di/dt current transducer such as a Rogowski coil may be implemented on a PCB by at least partially surrounding an opening/hole in the PCB with a coil formed by PCB conductive traces and vias. A conductor (eg, a conductive wire or rod) carrying the current to be sensed may be passed through the opening/hole in the PCB and any changes in the current carried by the conductor may be sensed by the di/dt transducer. The inventors have recognised that in this case, the PCB may present a convenient surface on which to position a conductive sense component for use in non-contact voltage sensing of the conductor.

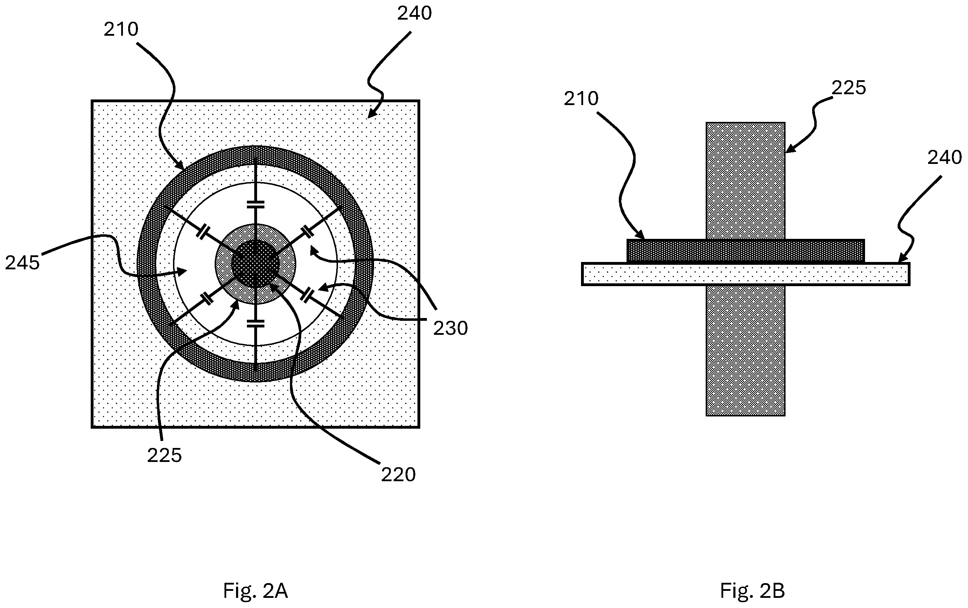

Figure 2A shows an example top-down view of a PCB 240 with a central opening through which a conductor 220 passes. The conductor 220 is coated with an insulator 225.

Figure 2B shows the same arrangement, but from a side-on view.

The PCB 240 includes a di/dt current transducer (such as a Rogowski coil) for current measurement purposes, although that is not represented in the Figures for the sake of simplicity. A ring-shaped conductive sense component 210 is position on the surface of the PCB 240 so as to completely surround the conductor 220 and capacitively 230 couple with the conductor 220. The capacitors 230 represented in Figure 2A are not capacitor components but instead represent the capacitive coupling formed between the conductor 220 and the conductive sense component 210, where the conductor 220 forms one plate of the "capacitor", the conductive sense component 210 the other plate of the "capacitor", and the insulating material therebetween (in this example, air and the insulator 225) form the dielectric of the "capacitor". As a result, an AC voltage of the conductor 220 will generate an AC sensing signal in the conductive sense component 210. Changes in the phase and/or magnitude of AC voltage will cause a corresponding change in the AC sensing signal. As such, the AC sensing signal can be used to sense the AC voltage.

Figures 2A and 2B show the conductive sense component 210 as a substantially circular ring, positioned on a PCB and fully surrounding the conductor 220. This shape may have a benefit of causing the coupling capacitance between the conductive sense component 210 and the conductor 220 to be relatively constant regardless of the position of the conductor 220 within the circle. However, this is merely one example. In an alternative, the conductive sense component 210 may only partially surround the conductor 220, for example being a split ring, or may be of a completely different shape, such as a rectangular plate that is simply positioned in proximity to a part of the conductor 220. Alternatively, it could be a series of plates arranged around the conductor 220, or a planar structure like a ruff/collar, formed as a separate piece or built into the PCB 240. In some examples it could be part of the internal edge of the PCB 240 (for example, plating the edge of the hole through which the conductor 220 passes, or formed as a series of conductive vias surrounding the hole through which the conductor 220 passes). Furthermore, regardless of the shape of the conductive sense component 210, it could be held in non-contacting proximity to the conductor 220 in any other suitable way. Furthermore, any insulating material may be present between the conductive sense component 210 and the conductor 220, including (but not limited to) air and/or an insulating material coating the conductor 220. For example, the conductive sense component 210 may be configured to be attached directly to the outer surface of the insulator 225. Regardless, the systems and methods described below are applicable to all designs and installations of conductive sense component 210, provided the conductive sense component 210 is suitable for positioning in non-contacting proximity to the conductor 220 so as to capacitively couple with the conductor 220.

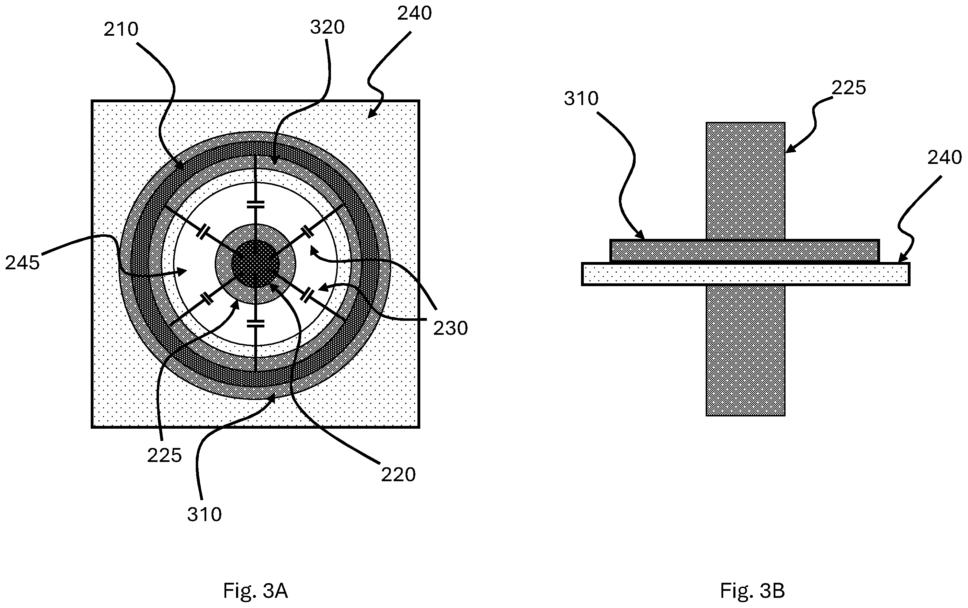

Figures 3A and 3B are similar to Figures 2A and 2B, but in this example, the conductive sense component 210 is coated with an insulator, such as plastic. The outer perimeter of the conductive sense component 210 is coated with an outer insulator 310 and the inner perimeter of the conductive sense component 210 is coated with an inner insulator 320.

Optionally, in the examples of both Figures 2A/B and 3A/B, a conductive shield may partially or completely surround the outer perimeter of the conductive sense component 210. In this way, parasitic capacitive coupling between the conductive sense component 210 and other conductors in its vicinity may be reduced or eliminated. The conductive shield may be any suitable size and shape, for example a conductive sleeve in the case of Figures 2A/B and 3A/B, within which the conductive sense component 210 fits.

In these examples, the conductor 220 has a circular cross section and the term "wire gauge" is typically used to describe the diameter of a circular cross section conductor (for example, in the American Wire Gauge - AWG - standard). However, the techniques described herein may be used to determine the size of the conductor regardless of its cross-sectional shape. For example, the conductor 220 may alternatively have a rectangular or square cross section (for example, it may be a conductor bar), in which case the "gauge" of the conductor 220 may be the thickness or width of the conductor. In a further alternative, the conductor 220 may be a multicore conductor, in which case the "gauge" of the conductor may be the overall diameter of the conductive core. Regardless, it should be understood that the term "gauge" used herein is not limited to the diameter/radius of a solid, circular cross-section conductor 220, but is instead intended to mean the size or thickness of the conductor 220, such as the width/depth/radius/circumference, etc.

Also, the term "wire" is intended to mean any type of conductor for carrying electrical current. The conductor may be flexible or rigid (such as a bar), it may have any cross-sectional shape, and may be single core or multicore.

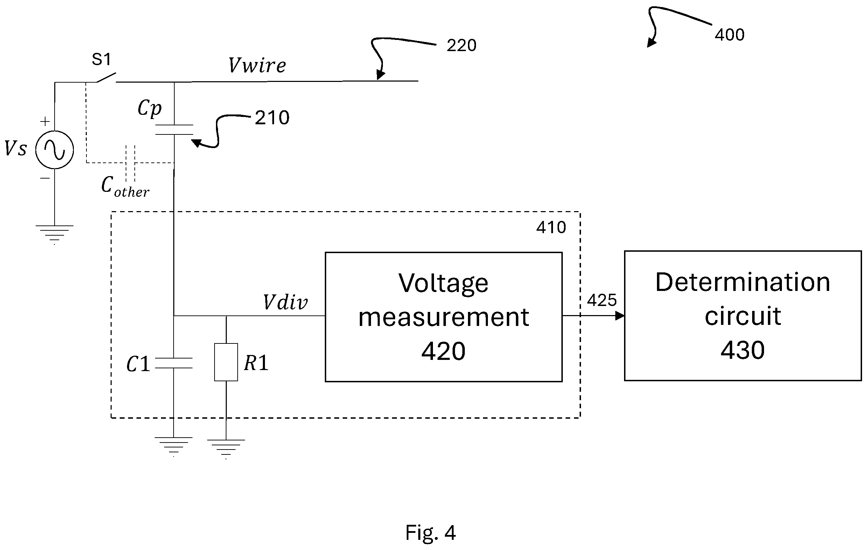

Figure 4 shows an example wire gauge determination system 400 in accordance with an aspect of this disclosure. The system 400 is configured to determine a gauge of the conductive wire 220 that is suitable for carrying a current and having a voltage Vwire. The conductor 220 is coupled to an AC source, Vs, via an optional switch S1, which may be a circuit breaker. The conductive sense component 210 is positioned in non-contacting proximity to the conductive wire 220 so as to capacitively couple with the conductor 220. That capacitive coupling is represented in Figure 4 by the capacitor Cp (which is the same as the capacitive coupling 230 shown in Figures 2A and 3A), with the conductive sense component 210 acting as one plate of the capacitor Cp and the conductive wire 220 acting as the other plate of the capacitor Cp. Also represented as Cother is further capacitive coupling, which may or may not be present between the conductive sense component 210 and other conductors in its vicinity, for example conductors carrying other phase voltages. In some installations Cother may be very small, or zero, and in others is may be more significant.

The system 400 comprises a measurement circuit 410 comprising a capacitor C1, resistor R1 and voltage measurement circuit 420. The capacitor C1 and resistor R1 are coupled in parallel, and in alternative implementations the measurement circuit 410 may comprise only one of the capacitor C1 and the resistor R1. The resistor R1 may set the DC level of Vdiv, in which example ensuring that Vdiv remains referenced to the ground reference. The capacitor C1 and the resistor R1 may be collectively referred to as an impedance component Z1, as follows:

$$Z1 = \frac{1}{\frac{1}{C1} + \frac{1}{R1}}$$

Alternatively, if only resistor R1 is present, then Z1 = R1, and if only the capacitor C1 is present, then Z1 = C1 (in which case, a different means may be used to set the DC level of Vdiv, such as a feedback signal). In the case of only R1 being present, the voltage measurement circuit 420 may also comprise an integrator in order to generate a flat frequency response for the voltage signal that is to be measured.

The impedance component Z1 is coupled to the conductive sense component 210 so as to form an impedance divider with the capacitive coupling Cp between the conductive wire 220 and the conductive sense component 210.

Vdiv may be expressed as:

$$Vdiv = \frac{Cp}{Cp + Z1} Vwire$$

In this expression, Cother is assumed to be zero, but the skilled person will appreciate that for non-zero values of Cother, each instance of "Cp" in the above may be replaced by "Cp+Cother".

The values of C1 and R1 may be chosen such that for the expected range of likely Vwire values, Vdiv should fall within the allowable input range of the voltage measurement circuit 420.

The capacitor C1 and/or resistor R1 are each coupled at one side (i.e., at a first terminal) to the conductive sense component 210 and at the other side (i.e., at a second terminal) to ground (although they could alternatively be coupled to any other suitable reference voltage). The capacitive coupling Cp, and the capacitor C1 and/or the resistor R1, together form an impedance divider to divide Vwire down to a smaller voltage Vdiv, which is dependent on Vwire (eg, if Vwire changes, Vdiv should also change). In this example implementation, the impedance divider also sets the DC level of the circuit to ground.

The voltage measurement circuit 420 is configured to measure a voltage that is dependent on a potential at the conductive sense component 210. In this example, the measured voltage is Vdiv, which is the AC sensing signal that is induced on the conductive sense component 210 by Vwire by virtue of the capacitive coupling Cp. The voltage measurement 425 is therefore representative of Vdiv.

The voltage measurement circuit 420 may take any suitable form, which will be well understood by the skilled person.

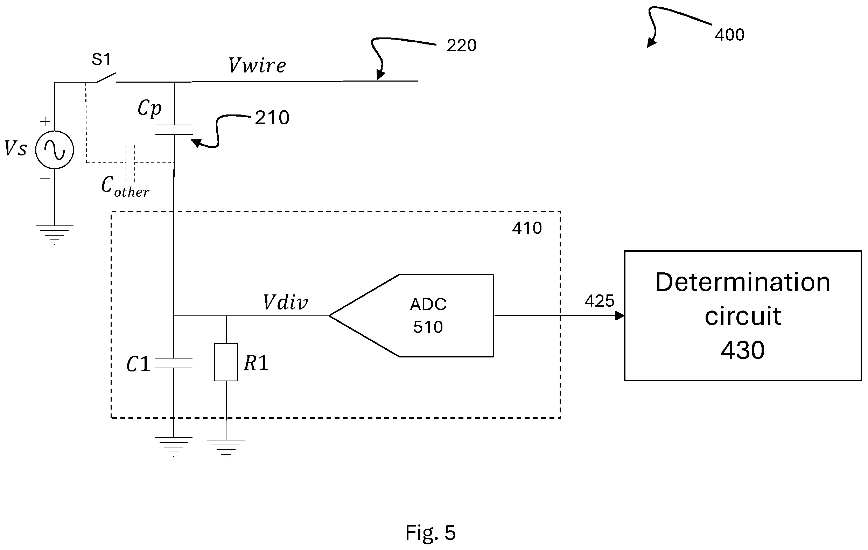

Figure 5 shows one example implementation of the voltage measurement circuit 420, in which an analog to digital converter (ADC) 510 is used. The ADC may be any suitable type of ADC, for example a Flash ADC, a SAR ADC, a pipelined ADC, a delta-sigma ADC, a ramp ADC, etc, and may have any suitable resolution. Whilst it is represented in Figure 5 as a single ended input and output, it may alternatively have a differential input and/or output.

The determination circuit 430 is configured to determine the capacitive coupling Cp between the conductive wire 220 and the conductive sense component 210 and, based on the determined Cp, determine the gauge of the conductive wire 220. The determination circuit 430 may comprise any suitable circuitry/processing means for performing the functionality described herein. For example, it may comprise any one or more of: dedicated, discrete circuitry; programable logic such as an FPGA; an application specific integrated circuit(s) (ASIC); a microcontroller unit(s) (MCU); a processor(s) such as a microprocessor(s) arranged to executed software instructions to perform the described functionality. The determination circuit 430 may also be implemented as functionality within a wider circuit/system/device, for example one that also performs other functions such as energy measurement, or it may be implemented as a dedicated circuit/system/device that performs only wire gauge determination.

In the examples of Figures 4 and 5, the determination circuit 430 may determine Cp based on the measured voltage 425 (which is representative of Vdiv, which in this example is the AC sensing signal induced at the conductive sense component 210 by Vwire), a known impedance of the impedance component Z1, and the AC voltage Vwire of the conductive wire 220 as follows:

$$Vdiv = \frac{Cp}{Cp + Z1}Vwire$$

$$Cp = \frac{Vdiv}{Vwire + Vdiv}Z1$$

Vwire may be known in a number of different ways. In this example, the conductive wire 220 is coupled to the supply voltage Vs which may be set/programmed to a specific value by the user, or may be measured by a voltage measurement arrangement (not represented in Figures 4 and 5 for the sake of efficiency, but the skilled person will understand the various different ways in which it could be measured, such as using the galvanic voltage measurement arrangement of Figure 1). When the switch S1 is closed, Vwire will equal Vs.

The impedance of Z1 is known since the values of R1 and C1 are selected at the time of system design (and optionally may have been measured during manufacture/calibration, if a high degree of accuracy is desired).

In this example, it has been assumed that Cother is zero or is negligible. Whilst this may affect the accuracy of Cp determination, the inventors have determined that for most practical implementations it is a reasonable assumption and the achieved accuracy is acceptable. This may be particularly true when conductive shielding is used to at least partially surround the outer perimeter of the conductive sense component 210, to reduced capacitive coupling with other conductors. When conductive shielding is used in the system implementations of Figures 4 and 5, it may be held at a reference voltage such as ground, and any capacitive coupling between the conductive sense component 210 and the shield may be determined either through simulation/modelling, or through measurement during calibration. This is because the capacitive coupling between the conductive sense component 210 and the shield is effectively in parallel with Cp, and will be included within the determination of Cp. By determining it through simulation/modelling, or through measurement during calibration, it may be extracted from the determination of Cp such that the true value of Cp may be more accurately determined.

From the determination of Cp, it is possible to determine the gauge of the conductive wire 220 in a number of different ways. The capacitance Cp is affected by the distance between the conductive sense component 210 and the conductive wire 220.

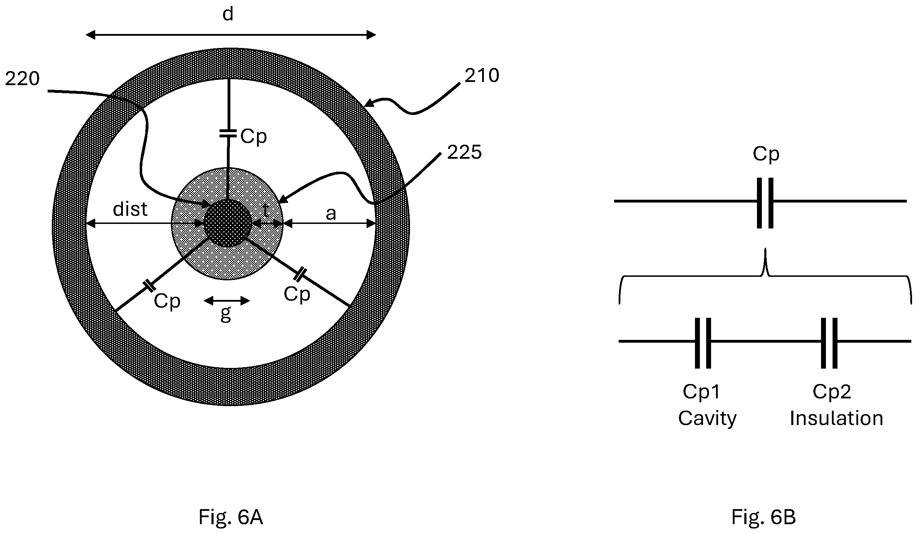

Figure 6A shows a visualisation of the arrangement of Figure 2A with the relevant dimensions:

d = inner diameter of the conductive sense component 210
dist = distance between the conductive sense component 210 and the conductive wire 220
t = thickness of insulator 225
g = gauge of conductive wire 220 (i.e., in this example, the diameter of the conductive wire 220)

$$g = d - 2dist$$

Figure 6B shows the composition of capacitances making up Cp. Because there are two types of insulators between the conductive sense component 210 and the conductive wire 220 (the cavity, that is likely filed with air, and the wire insulation 225), the capacitance is effectively made up of two parts Cp1 and Cp2.

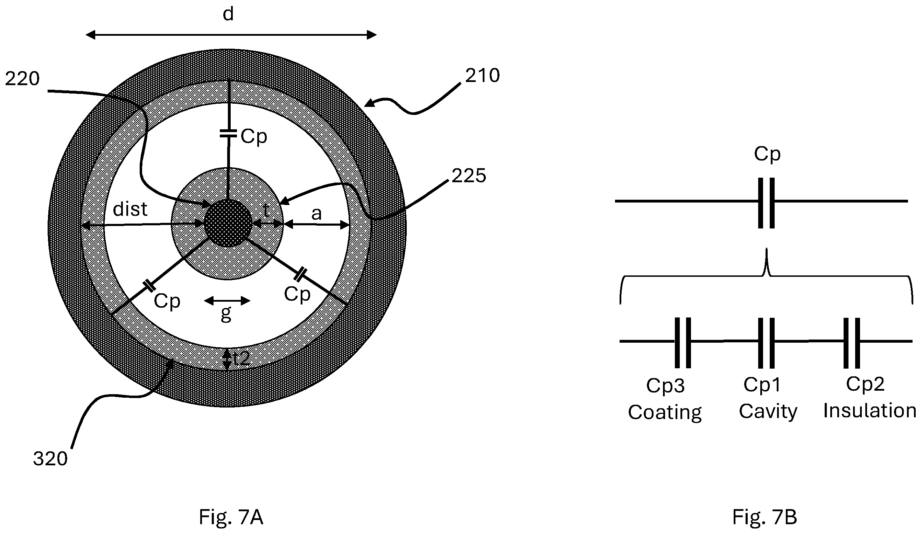

Figure 7A shows a visualisation of the arrangement of Figure 3A with the relevant dimensions, which are very similar to those of Figure 6A, but with an additional dimension t2, which is the thickness of the inner, insulative coating 320 of the conductive sense component 210.

Figure 7B shows the composition of capacitances making up Cp, which is very similar to that of Figure 6B, but with an additional component Cp3, corresponding to the contribution of the insulative coating 320.

From these representations, it will be understood that the overall determined capacitance Cp is dependent on "dist", as well as the permittivity $\varepsilon_r$ and thickness/distance of each insulative material. Since "dist" is dependent on the gauge g, "dist" will be different for different gauge wires, which in turn will cause different values of Cp, assuming all other factors (such as the relative permittivity of air and the thickness and relative permittivities of the insulators 225 and 320) remain substantially the same. Consequently, it is possible to use the determination of Cp to determine the gauge g.

There are many different ways in which a determination of Cp can be used to determine the gauge of the conductive wire 220.

In one example, an electromagnetic model (eg, "digital twin") or simulation based approach may be employed. For example, a model, or digital twin, may be created based on the known properties of the conductive sense component 210 (such as size and shape of the conductor, as well as thickness t and material type of the coating 320 in the example of Figure 7A) and various different types of conductive wire 220 (for example, different gauges of wire, different material types of insulator 225, etc). Based on that model, as well as known physical principles of capacitance that define a dependence on distance between conductors and the relative permittivity of the insulative material(s) between the two conductors, a relationship between the dimension "dist" (which is dependent on gauge g) and the capacitance Cp may be understood. Using this relationship, an estimate for gauge g may be determined from capacitance Cp. In one example, the model may simply assume a value for thickness t, the conductor 220 type (for example, solid core, multicore, rectangular bar, etc), material type of the insulator 225 (and the relative permittivity of that material $\varepsilon_r$), and the relative permittivity of the air in the gap between the insulator 225 and the conductive sense component 210 (for example, based on an assumption that the air temperature is 20 degC). In an alternative, an operator may be given an opportunity to enter values for any one or more of those factors, which may improve the accuracy of the model, and therefore the accuracy of the determined value for gauge g.

In a further example, the determination circuit 430 may store, for example in memory that is part of the determination circuit 430, one or more values of Cp and corresponding values for wire gauge (or have access to such a store held in memory elsewhere). For example, they may be stored in a look-up table, or database, etc. The determination circuit 430 may then use any suitable extrapolation and/or interpolation techniques to determine the gauge of the conductive wire 220 using the determined value of Cp, the stored value(s) of Cp and their associated stored values for wire gauge. For example, the determination circuit may identify the closest stored Cp below the determined Cp and the closest stored Cp above the determined Cp, and then interpolate (using any suitable algorithm) between the two corresponding stored wire gauges in order to determine the gauge of the conductive wire 220.

The stored values may be determined in a number of different ways. In one example, simulation models (eg digital twins) may be used for a variety of different wire gauges g, to generate an expected value for Cp for each. Optionally, this may be repeated for each variable that the user may have an opportunity to define, such as conductor 220 type (solid core, multicore, etc), insulator 225 thickness and/or material type, temperature, etc, so that for each combination of variables defined by the user, there is a suitable set of stored Cp's and corresponding gauge g values. In a further example, on a system-by-system basis, calibration may take place whereby after manufacture of the system, a conductive wire 220 of known gauge is put in place and a value for Cp is determined. The known gauge of the wire and the determined Cp may then be stored in association with one another. This may be repeated one or more times with conductive wires of different known gauges and/or conductor 220 types (solid core, multicore, etc) and/or insulator 225 material types/thickness, etc. By doing this for each manufactured system, a high level of accuracy may be achieved, as any inaccuracies in Cp determination caused by manufacturing imperfections should be reduced or removed. For example, inaccuracies in the size and/or shape of the conductive sense component 220 and/or in the thickness and material properties of the insulative coating 320 (if present) and/or in the geometry of any shielding components (if present) and/or in the value of Z1, and/or in the accuracy of any other components (such as the voltage measurement circuit 420) should not affect accuracy since the measurement is done on a per system basis. However, in an alternative, it may simply be performed for each particular design of system, and the results applied to all other systems manufactured to that design. Whilst that may be slightly less accurate, because system-to-system variations caused by manufacturing imperfections will not be reflected in the stored values for Cp and wire gauge, for many purposes the system will still determine wire gauge with sufficient accuracy. In a further alternative, a compromise between these two positions may be adopted. For example, stored Cp and corresponding gauge values may be determined for a particular system design and used for all manufactured units of the same design. However, for each unit, a calibration may be performed, where, for example, a conductive wire 220 of known gauge is positioned within each unit and Cp determined. This value may then be compared against the stored value of Cp for that gauge of wire, in order to determine a correction factor. That correction factor may then be applied during system operation to improve the accuracy of the determined gauge g. This technique may be even further improved by repeating the process with at least one further conductor wire 220 of a different known gauge, in order to determine a more accurate correction factor. In this way, the detrimental effect of unit-by-unit manufacturing differences on the accuracy of gauge determination may be reduced, whilst still minimising the amount of per-unit calibration that is required. Whilst this technique is described with particular reference to the stored Cp and gauge g technique, it may also be applied to the model/simulation based technique described above, in order to improve the accuracy of the gauge determination using a model/simulation of the system.

Whilst these techniques may enable wire gauge to be determined with a reasonable level of accuracy, they assume various factors do not change over time. Whilst for many applications this is a reasonable assumption, for some applications it may not be. For example, some factors affecting the accuracy of determination of Cp may be influenced by environment conductions, such as air temperature and/or humidity. In particular, humidity may affect the dielectric constant of air, which in turn affects the capacitance Cp1, and therefore affects Cp. In another examples, the thermal expansion coefficient of the materials could change the size and/or shape of the conductive sense component 210, which again will affect Cp. Furthermore, component aging may affect the determination of Cp, such as the electrical parameters of the measurement circuit 410 and/or the dimensions of the mechanical components such as the conductive sense component 210.

To reduce or remove such inaccuracies, the system 400 could be configured to include one or more additional reference channels. For example, a reference channel may comprise an additional conductive sense component 210 (a reference conductive sense component) that is the same design as Figure 4/5. The additional conductive sense component 210 may be positioned in proximity to an additional conductive wire 220 (a reference conductive wire) that has a known gauge. Throughout the life of the system 400, when determining the gauge of an unknown conductive wire, the determination circuit 430 may determine a Cp for the reference channel and use that to determine the gauge for the conductive wire in the reference channel (using any of the techniques described above). That determined value may be compared against the known gauge for that wire (which may be stored, for example, in memory) in order to determine a correction factor. To determine the gauge of the unknown wire, the determination circuit 430 may determine Cp for that channel and use it to determine an initial value for wire gauge (using any of the techniques described above). The gauge of the conductive wire 220 may then be determined by applying the correction factor to the initial value for the wire gauge, such that the determined gauge for the conductive wire 220 includes compensation for any changes in environmental conditions.

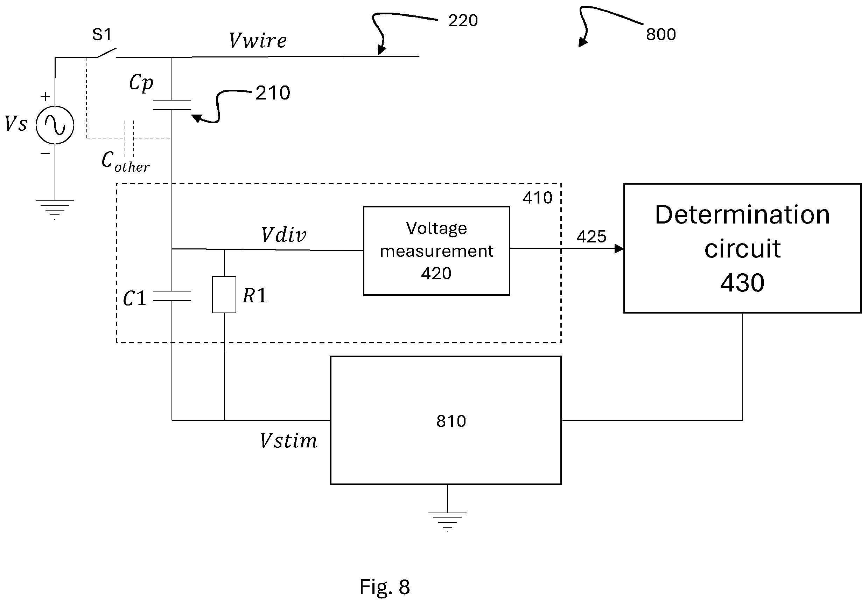

Figure 8 shows a further example system 800 in accordance with the present disclosure. System 800 is very similar to system 400, but is configured to determine Cp in a different way. The determination circuit 430 may then use Cp to determine the gauge of the conductive wire 220 using any of the techniques described above.

The system 800 comprises a reference voltage generator 810 configured to generate a reference voltage Vstim. The reference voltage generator 810 is coupled to the measurement circuit 410 so as to apply the reference signal Vstim to the measurement circuit 410 such that the potential Vdiv at the conductive sense component 210 comprises a resultant signal Vres that is dependent on the reference signal Vstim. In this example, the resultant signal Vres is a divided down version of Vstim, that is divided by an amount set by the ratio of the impedance divider formed by the impedance component Z1 and the capacitive coupling Cp. In the example of Figure 8, Vstim is applied to the bottom of the impedance divider formed by Z1 and Cp.

If a conductive shield is utilised to partially or wholly surround the outer perimeter of the conductive sense component 210 in order to reduce/eliminate parasitic capacitive coupling Cother (as explained earlier), a signal based on Vstim may also be applied to the conductive shield. For example, Vstim may be directly applied to the conductive shield, or a Vstim plus a DC offset (for example, as a result of putting Vstim through a buffer before applying it to the shield, which may introduce a DC offset and/or noise) may be applied to the conductive shield. Consequently, the modulation (eg, the AC signal) applied to the conductive sense component 210 should be substantially the same as the modulation applied to the shield (for example, the same to within +/- 1%, or +/- 2%, or within +/- 5%), meaning that capacitance between the shield and the conductive sense component 210 is not charged.

The reference voltage generator 810 is coupled to, and controlled by, the determination circuit 430 so that the determination circuit 430 can control when Vstim is applied (although in an alternative it may be controlled by any other suitable circuit/unit/device). Furthermore, in some instances the determination circuit 430 may control the characteristics of Vstim, such as its magnitude and/or frequency, although in other instances the characteristics may be fixed and the reference voltage generator 810 simply be turned on and off.

The magnitude of Vstim is known, as is the impedance of Z1. Since Vdiv comprises the resultant signal Vres, the determination circuit 430 may use the voltage measurement 425 to determine the capacitance Cp. For example, if the magnitude of Vres is half that of Vstim, then the determination circuit 430 can determine that the impedance of Cp is the same as the known impedance of component Z1.

In some instances, the determination circuit 430 may be configured to determine Cp using this technique when it is identified that S1 is open. For example, when the determination circuit 430 identifies that Vdiv is zero, it may initiate the process of determining the capacitance Cp and turn on the application of Vstim. In this case, Vdiv should equal Vres, and Vstim may have any signal characteristic, such as being a DC signal or an AC signal having any frequency. In a further example, determination of Cp may be performed during manufacture and/or calibration, in which case again Vstim may be a DC signal or an AC signal having any frequency.

In other instances, the system 800 may be configured such that the determination circuit 430 may determine the capacitance of Cp at any time, for example in the field during operation of the wider electrical system. Consequently, Vdiv would comprise the AC sensing signal (induced by Vwire) and also Vres. In this case, the reference voltage Vstim may be a signal having characteristics that make it extractable from the voltage measurement 425, so it may be isolated from the AC sensing signal and used for determination of Cp. For example, it may be an AC signal with a frequency that is different to the expected frequency of Vwire (and optionally different also to expected harmonics of Vwire), and therefore different to the expected frequency of the AC sensing signal.

If Vstim is an AC signal, it may have any suitable shape, such as a square wave signal, a triangle wave signal, a sinusoidal wave signal, etc. In one particular example, the reference voltage generator 810 may be a digital to analog converter (DAC), wherein the determination circuit 430 supplies one or more digital values to the input of the DAC at the desired frequency for Vstim. For example, it may supply a digital signal that alternates between two digital levels (such as 0 and a non-zero digital value) at the desired frequency for Vstim, so as to generate a square wave signal of known magnitude and frequency.

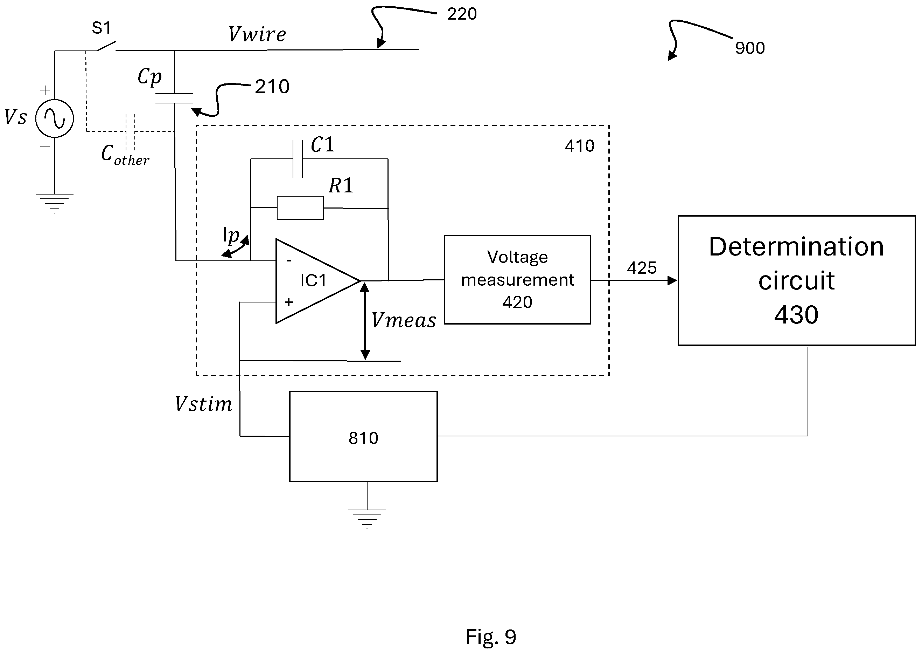

Figure 9 shows a system 900 in accordance with a further aspect of the disclosure. The system 900 shows an alternative way in which Vstim may be applied to the measurement circuit 410 so that the potential at the conductive sense component 210 comprises Vres. In this example, the measurement circuit 410 further comprises an op amp IC1 having a first input (in this example the inverting input, although it could alternatively be the non-inverting input) coupled to the conductive sense component 210 and a second input (in this example the non-inverting input, although it could alternatively be the inverting input) coupled to the reference voltage generator 810. As a result, Vstim is applied to the second input of op amp IC1 and correspondingly also the first input of op amp IC1 as a result of the virtual earth operation of op amp IC1. The measurement circuit 410 is also arranged such that the impedance component Z1 forms a feedback path between the op amp output and the first input. In this example, the voltage measurement circuit 420 is arranged to measure the voltage Vmeas, which is a voltage that is dependent on the potential at the conductive sense component 210 (i.e. if the potential at the conductive sense component 210 changed, then Vmeas also changed).

This arrangement is one way to determine Cp using a "capsense" method where the reference voltage Vstim (typically an AC voltage) is applied to the bottom terminal of Cp (specifically the conductive sense component 210), such that the current Ip that comes from the change in potential across Cp can be measured. In this particular example, by measuring Vmeas, which comprises Vres (and optionally also the AC sensing signal), and knowing the magnitude of Vstim, the determination circuit 430 can determine the divider ratio of the impedance divider formed by Z1 and Cp. Since Z1 is also known, Cp can then be determined. As explained above with reference to Figure 8, if Vmeas comprises both the AC sensing signal and Vres, then Vres can be extracted from the voltage measurement 425 by knowing the frequency of Vstim.

In both of systems 800 and 900, the determination circuit 430 (or any other suitable circuit/unit/device) may optionally also measure Vwire. In particular, once Cp is determined, then a divider ratio for the impedance divider will be known, since Z1 is known. When Vdiv or Vmeas comprise the AC sensing signal, then the determination circuit 430 may identify the AC sensing signal from the voltage measurement 425 (either by turning off Vstim so that the voltage measurement 425 includes only the AC sensing signal, or by extracting it from the voltage measurement 425) and determine a measurement of Vwire from the measured AC sensing signal and the impedance divider ratio. This could be used to detect unusual voltage drops across the switch S1 and/or to indicate a bad connection between the conductive wire 210 and the switch S1.

In some examples, Z1 will only be known to an approximate degree of accuracy, for example +/- 5%, based on the quoted manufacturing accuracy of C1 and/or R1. This will affect the accuracy with which the impedance divider ratio is known, and therefore the accuracy with which Vwire is determined. For some applications, this may be sufficiently accurate. For other applications, a higher degree of accuracy may be desired. In this case, the value of Z1 may be determined during calibration/manufacture, for example by directly measuring the impedance Z1, or by using a conductor 220 of known gauge and setting Vwire to known voltage. C1 may then be determined by measuring Vdiv (or Vmeas) and using the known values for Vwire and Cp.

Whilst the system 900 shows one particular way of implementing a "capsense" method, other techniques may alternatively be used to apply the reference voltage Vstim (typically an AC voltage) to the bottom terminal of Cp (specifically the conductive sense component 210).

As can be seen from Figures 4, 5, 8 and 9, the wire gauge determination system of the present disclosure may be implemented in various different ways in order to determine the capacitance Cp.

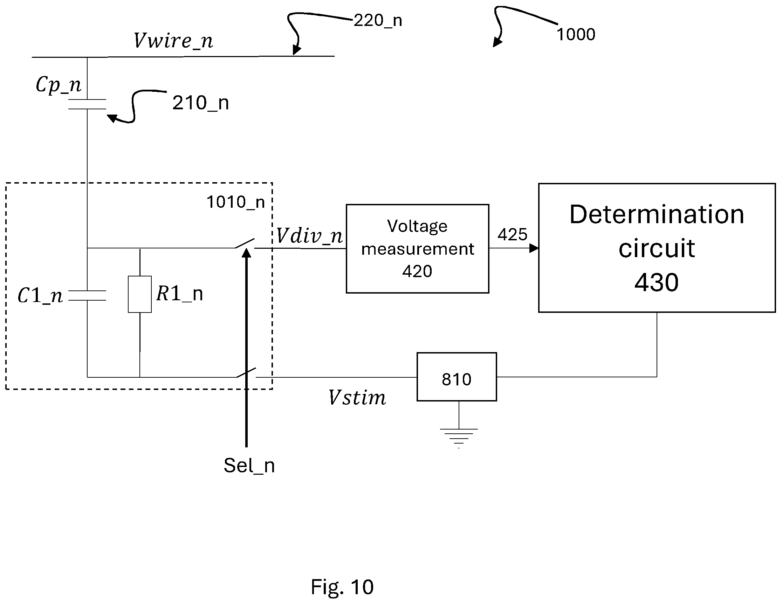

Figure 10 shows an example modification of the system 800 that may be used for determining the gauge of more than one conductive wire in a wider system, such as a multi-phase system. In the system 1000, the measurement circuit 1010_n is the same as the measurement circuit 410 of system 800, but further includes switches to controllably couple/decouple the reference voltage generator 810 and the voltage measurement circuit 420 to the measurement circuit 1010_n using control signal Sel_n. The switches may be implemented in any suitable way, for example using transistors (such as FETs or bipolar transistors), relays, etc. In this example, the voltage measurement circuit 420 is outside of the measurement circuit 1010_n so that a single voltage measurement circuit 420 can be used for multiple different conductive wires 220_n (as will be appreciated later). In an alternative, each measurement circuit 1010_n may include a voltage measurement circuit 420_n, in which case a switch may be position in the measurement circuit 1010_n for coupling/decoupling the voltage measurement circuit 420_n to the determination circuit 430. Whilst system 1000 is based on a modification of system 800, it will be appreciated that the system 1000 may alternatively be based on the arrangement of system 400, where there is no reference voltage generator 810.

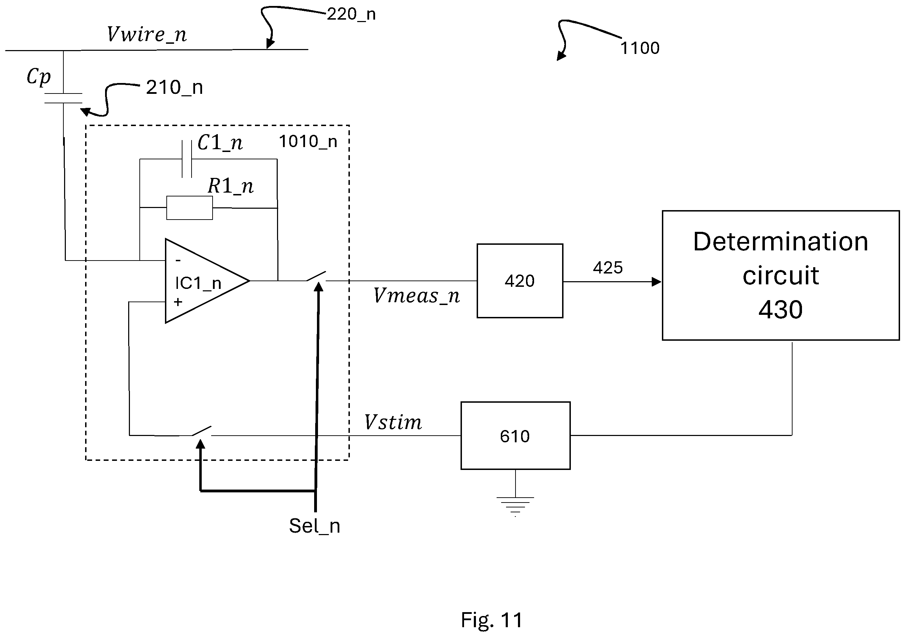

Figure 11 shows an example modification of the system 900 that may be used for determining the gauge of more than one conductive wire in a wider system, such as a multi-phase system. In the system 1100, the measurement circuit 1010_n is similar to the measurement circuit 410 of system 900, but further includes two controllable switches, which serve the same purpose as those of system 1000. Again, in this example the voltage measurement circuit 420 is outside of the measurement circuit 1010_n, but it may alternatively be within it, as explained above. In an alternative, rather than using switches, circuit 1010_n could be configured such that the select control signal Sel_n sets the op amp IC1_n of all non-selected comparison circuits 1010_n to its high impedance state (i.e., its powered down state, where the op amp output goes to high impedance), such that those comparison circuits 1010_n are effectively put into a non-operational state, and set the op amp IC1 of the selected comparison circuit 1010_n to a low-impedance state (i.e., its powered up state, where the comparator output goes to low impedance), such that that selected circuit 1010_n is effectively put into an operational state.

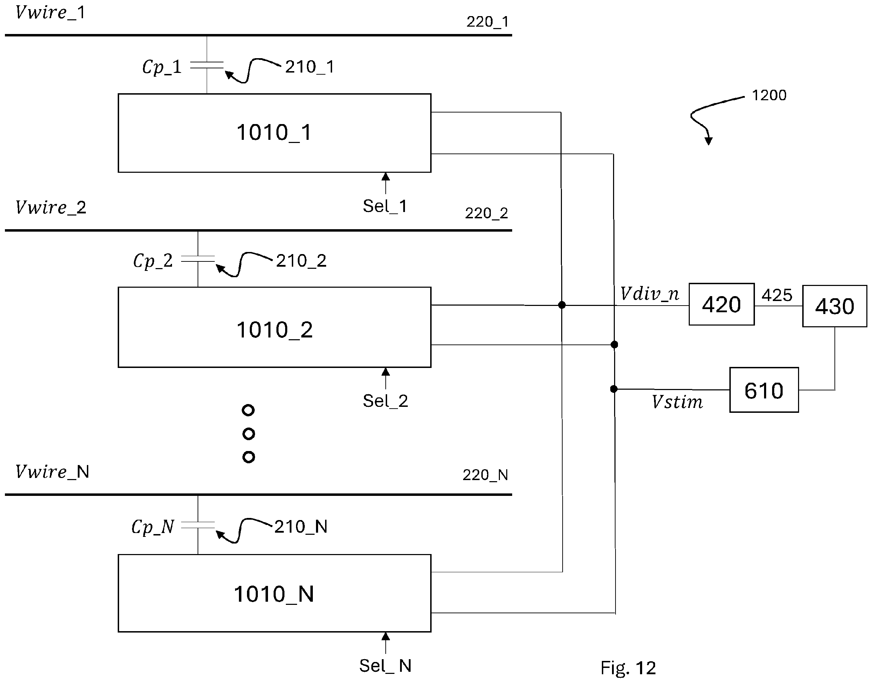

Figure 12 shows an example of how the measurements circuits 1010_n may be used. In this example, there are N conductive wires 220_N and a corresponding N measurement circuits 810_N. By controlling the Sel_n signals, the switches of one of the measurement circuits 1010_n may closed in order to couple the elected measurement circuit to the voltage measurement circuit 420 and reference voltage generator 610. The switches of all other measurement circuits 1010_n may be held in an open state. As a result, the gauge of each of the wires 220_N may be determined consecutively, in serial, by serially closing the switches of one measurement circuit 1010_n at a time and keeping all other switches open. As a result, for a multi-conductor system, such as that of Figure 1, the gauge of multiple different conductive wires may be determined using a single voltage measurement circuit 420, determination circuit 430 and reference voltage generator 610, thereby minimising costs and space. It should be noted that if a reference channel is desired, for example to increase wire gauge determination accuracy (as explained earlier), one or more of the conductive wires 220_n may be of a known gauge, and the corresponding conductive sense conductor(s) 210_n and measurement circuit(s) 1010_n may be used as the reference channel(s).

For all of the systems described above, the determination circuit 430 may be configured to output an indication of the determined wire gauge, for example to another device/unit. In this way, the determined wire gauge may be communicated to a user/operator, for example in audio, visual, textual, etc form, and/or to any other suitable entity/system, such as a monitoring system, such that the user/operator may understand what the determined gauge is, and take action if necessary. Optionally, the determined wire gauge may be combined with further measurements/information that are indicative of the current handling capability of the conductor 220, such as temperature measurements and/or $I^2R$ drops over a long feed.

Additionally or alternately, the determination circuit 430 may be further configured to receive a current measurement corresponding to the conductive wire 210 for which the gauge has been determined (for example, from a current measurement circuit, such as that represented in Figure 1). Using this, it may generate a warning (such as audio, visual, textual, etc) if the measured current exceeds the maximum safe current that can be carried by the determined gauge of conductive wire. The generated warning may be output from the determination circuit 430 for conveying to an operator/controller of the system, so that action may be taken, and/or to any other suitable entity/system, such as a monitoring system. Additionally or alternatively, the determination circuit 430 may receive (or store in memory) an indication of the desired maximum current for the conductive wire 210, for example from a user/operator. If the determined gauge is not suitable for carrying such a current, it may again generate a warning for outputting to the user/operator and/or any other suitable entity. Additionally or alternatively, the determination circuit 430 may be aware of what gauge of wire should be used (for example, from earlier user entry) and, if the determined gauge is different (for example, more than +/-1%, more than +/-2%, more than +/-5%, more than +/-10%), it may generate a warning for outputting to the user/operator and/or any other suitable entity.

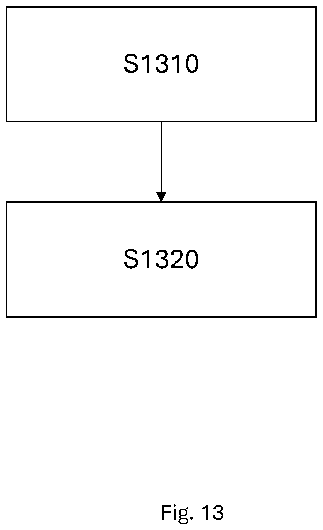

Figure 13 shows an example method of determining wire gauge. Step S1310 comprises determining a capacitive coupling Cp between the conductive wire 220 and the conductive sense component 210, using any of the techniques described earlier. Step S1320 comprises determining the gauge of the conductive wire 220 based on the determined capacitive coupling Cp. The method may be performed by any suitable device/circuit/system, such as the determination circuit 430.

The terminology "coupled" used above encompasses both a direct electrical connection between two components, and an indirect electrical connection where the two components are electrically connected to each other via one or more intermediate components.

The skilled person will readily appreciate that various alterations or modifications may be made to the above described aspects of the disclosure without departing from the scope of the disclosure.

## Aspects of the disclosure

Non-limiting aspects of the disclosure are set out in the following numbered clauses:

1. A wire gauge determination system comprising:

a conductive sense component for positioning, when in use, in non-contacting proximity to a conductive wire so as to capacitively couple with the conductive wire to generate an AC sensing signal at the conductive sense component, wherein the AC sensing signal is dependent on an AC voltage of the conductive wire; a determination circuit coupled to the conductive sense component and configured to:

determine a capacitive coupling between the conductive wire and the conductive sense component; and determine a gauge of the conductive wire based on the determined capacitive coupling between the conductive wire and the conductive sense component.

2. The system of clause 1, further comprising:

a measurement circuit coupled to the conductive sense component and the determination circuit, wherein the measurement circuit is configured to:
measure a voltage that is dependent on a potential at the conductive sense component, wherein the determination circuit is configured to determine the capacitive coupling between the conductive wire and the conductive sense component further based on the measured voltage.

3. The system of clause 2, wherein the measurement circuit further comprises an impedance component coupled to the conductive sense component so as to form an impedance divider with the capacitive coupling between the conductive wire and the conductive sense component, wherein the determination circuit is configured to determine the capacitive coupling between the conductive wire and the conductive sense component further based on an impedance of the impedance component.

4. The system of clause 3, wherein the impedance component comprises at least one of: a capacitor; a resistor.

5. The system of any of clauses 2 to 4, wherein the measured voltage comprises the AC sensing signal at the conductive sense component, and wherein the determination circuit is configured to determine the capacitive coupling between the conductive wire and the conductive sense component further based on the AC sensing signal and the AC voltage of the conductive wire.

6. The system of clause 4, further comprising:

a conductive shield arranged to at least partially surround an outer perimeter of the conductive sense component, wherein the system is further configured to apply a reference voltage to the conductive shield.

7. The system of any of clauses 2 to 4, further comprising:

a reference signal generator configured to generate a reference signal, wherein the reference signal generator is coupled to the measurement circuit so as to apply the reference signal to the measurement circuit such that the potential at the conductive sense component comprises a resultant signal that is dependent on the reference signal, wherein the determination circuit is configured to determine the capacitive coupling between the conductive wire and the conductive sense component further based on the resultant signal and the reference signal.

8. The system of clause 7, wherein the reference signal is an alternating signal having a frequency that is different to that of the AC voltage.

9. The system of clause 7 or clause 8, wherein the measurement circuit comprises a voltage measurement circuit arranged to measure the potential at the conductive sense component.

10. The system of clause 7 or clause 8, wherein the measurement circuit comprises an op amp comprising:

a first input coupled to the conductive sense component; a second input coupled to the reference signal generator, such that the reference signal is applied to the second input and correspondingly the first input as a result of the virtual earth operation of the op amp; an output; and a feedback path between the output and the first input, wherein the feedback path comprises an impedance component that forms an impedance divider with the capacitive coupling between the conductive wire and the conductive sense component; and

a voltage measurement circuit arranged to measure a voltage at the output of the op amp, wherein the measured voltage comprises the resultant circuit.

11. The system of any of clauses 7 to 10, further comprising:

a conductive shield arranged to at least partially surround an outer perimeter of the conductive sense component,
wherein the system is further configured to apply to the conductive shield a signal that is based on the reference signal.

12. The system of any of clauses 2 to 11, wherein the determination circuit is further configured to:
measure the AC voltage of the conductive wire based on the measured voltage and the determined capacitive coupling between the conductive wire and the conductive sense component.

13. The system of any preceding clause, wherein the determination circuit is configured to determine the gauge of the conductive wire using an electromagnetic model of the conductive sense component and the conductive wire that represents a relationship between wire gauge and the capacitive coupling between the conductive wire and the conductive sense component.

14. The system of any preceding clause, wherein the determination circuit is configured to determine the gauge of the conductive wire using one or more stored values of capacitive coupling and an associated one or more stored values for wire gauge.

15. The system of clause 14, wherein determination of the gauge of the determination circuit is configured to determine the gauge of the conductive wire using one of:

extrapolation from the closest stored capacitive coupling value to the determined capacitive coupling between the conductive wire and the conductive sense component;
interpolation between the two closest stored capacitive coupling values to the determined capacitive coupling between the conductive wire and the conductive sense component.

16. The system of any preceding clause, further comprising:

a reference conductive sense component for positioning, when in use, in non-contacting proximity to a reference conductive wire of a known gauge so as to capacitively couple with the reference conductive wire,
wherein the determination circuit is coupled to the reference conductive sense component and is further configured to:

determine a capacitive coupling between the reference conductive wire and the reference conductive sense component;
determine a gauge of the reference conductive wire based on the determined capacitive coupling between the reference conductive wire and the reference conductive sense component;
determine a correction factor by comparing the determined gauge of the reference conductive wire and the known gauge of the reference conductive wire; and
determine the gauge of the conductive wire further based on the correction factor.

17. The system of any preceding clause, wherein the determination circuit is further configured to:

receive an indication of maximum current for the conductive wire;
determine whether the determined gauge of the conductive wire is suitable for the indicated maximum current for the conductive wire; and
if it is not suitable, output a warning.

18. The system of any preceding clause, wherein the determination circuit is further configured to:

receive a measurement of current carried by the conductive wire;
determine whether the determined gauge of the conductive wire is suitable for the current carried by the conductive wire; and
if it is not suitable, output a warning.

19. A method for determining wire gauge, the method comprising:

determining a capacitive coupling between a conductive wire and a conductive sense component, wherein the conductive sense component is positioned in non-contacting proximity to the conductive wire so as to capacitively couple with the conductive wire to generate an AC sensing signal at the conductive sense component, wherein the AC sensing signal is dependent on an AC voltage of the conductive wire; and
determining a gauge of the conductive wire based on the determined capacitive coupling between the conductive wire and the conductive sense component.

20. The method of clause 19, further comprising:

measuring a voltage that is dependent on a potential at the conductive sense component, wherein determining the capacitive coupling between the conductive wire and the conductive sense component is further based on the measured voltage.

21. The method of clause 20, wherein determining the capacitive coupling between the conductive wire and the conductive sense component is further based on the AC voltage of the conductive wire.

22. The method of clause 20, further comprising:

applying a reference signal to the measurement circuit such that the potential at the conductive sense component comprises a resultant signal that is dependent on the reference signal, wherein determining the capacitive coupling between the conductive wire and the conductive sense component is further based on the resultant signal and the reference signal.

23. The method of any of clauses 20 to 22, further comprising:
measuring the AC voltage of the conductive wire based on the measured voltage and the determined capacitive coupling between the conductive wire and the conductive sense component.

24. The method of any of clauses 19 to 23, wherein determining the gauge of the conductive wire comprises using an electromagnetic model of the conductive sense component and the conductive wire that represents a relationship between wire gauge and the capacitive coupling between the conductive wire and the conductive sense component.

25. The method of any of clauses 19 to 24, wherein determining the gauge of the conductive wire comprises using one or more stored values of capacitive coupling and an associated one or more stored values for wire gauge.

26. The method of clause 25, wherein determining the gauge of the conductive wire comprises using one of:

extrapolation from the closest stored capacitive coupling value to the determined capacitive coupling between the conductive wire and the conductive sense component; interpolation between the two closest stored capacitive coupling values to the determined capacitive coupling between the conductive wire and the conductive sense component.

27. The method of any of clauses 19 to 26, further comprising:

determining a capacitive coupling between a reference conductive wire of a known gauge and a reference conductive sense component, wherein the reference conductive sense component is for positioning, when in use, in non-contacting proximity to the reference conductive wire so as to capacitively couple with the reference conductive wire; determining a gauge of the reference conductive wire based on the determined capacitive coupling between the reference conductive wire and the reference conductive sense component; determining a correction factor by comparing the determined gauge of the reference conductive wire and the known gauge of the reference conductive wire; and determining the gauge of the conductive wire further based on the correction factor.

28. The method of any of clauses 19 to 27, further comprising:

receiving an indication of maximum current for the conductive wire; determining whether the determined gauge of the conductive wire is suitable for the indicated maximum current for the conductive wire; and if it is not suitable, outputting a warning.

29. The method of any of clauses 19 to 28, further comprising:

receiving a measurement of current carried by the conductive wire; determining whether the determined gauge of the conductive wire is suitable for the current carried by the conductive wire; and if it is not suitable, output a warning.

30. An electrical system comprising:

a conductive wire for carrying an electrical current; a conductive sense component positioned in non-contacting proximity to the conductive wire so as to capacitively couple with the conductive wire to generate an AC sensing signal at the conductive sense component, wherein the AC sensing signal is dependent on an AC voltage of the conductive wire; a determination circuit coupled to the conductive sense component and configured to:

determine a capacitive coupling between the conductive wire and the conductive sense component; and determine a gauge of the conductive wire based on the determined capacitive coupling between the conductive wire and the conductive sense component.

**Claims**

1. A wire gauge determination system comprising:

   a conductive sense component for positioning, when in use, in non-contacting proximity to a conductive wire so as to capacitively couple with the conductive wire to generate an AC sensing signal at the conductive sense component, wherein the AC sensing signal is dependent on an AC voltage of the conductive wire; a determination circuit coupled to the conductive sense component and configured to:

   determine a capacitive coupling between the conductive wire and the conductive sense component; and determine a gauge of the conductive wire based on the determined capacitive coupling between the conductive wire and the conductive sense component.

2. The system of claim 1, further comprising:

   a measurement circuit coupled to the conductive sense component and the determination circuit, wherein the measurement circuit is configured to:

   measure a voltage that is dependent on a potential at the conductive sense component, wherein the determination circuit is configured to determine the capacitive coupling between the conductive wire and the conductive sense component further based on the measured voltage.

3. The system of claim 2, wherein the measurement circuit further comprises an impedance component coupled to the conductive sense component so as to form an impedance divider with the capacitive coupling between the conductive wire and the conductive sense component, wherein the determination circuit is configured to determine the capacitive coupling between the conductive wire and the conductive sense component further based on an impedance of the impedance component.

4. The system of claim 2 or claim 3, wherein the measured voltage comprises the AC sensing signal at the conductive sense component, and wherein the determination circuit is configured to determine the capacitive coupling between the conductive wire and the conductive sense component further based on the AC sensing signal and the AC voltage of the conductive wire.

5. The system of claim 4, further comprising:

   a conductive shield arranged to at least partially surround an outer perimeter of the conductive sense component, wherein the system is further configured to apply a reference voltage to the conductive shield.

6. The system of claim 2 or claim 3, further comprising:

   a reference signal generator configured to generate a reference signal, wherein the reference signal generator is coupled to the measurement circuit so as to apply the reference signal to the measurement circuit such that the potential at the conductive sense component comprises a resultant signal that is dependent on the reference signal, wherein the determination circuit is configured to determine the capacitive coupling between the conductive wire and the conductive sense component further based on the resultant signal and the reference signal.

7. The system of claim 6, wherein the measurement circuit comprises:

   (a) a voltage measurement circuit arranged to measure the potential at the conductive sense component; or
   (b) an op amp comprising:

   a first input coupled to the conductive sense component; a second input coupled to the reference signal generator, such that the reference signal is applied to the second input and correspondingly the first input as a result of the virtual earth operation of the op amp; an output; and a feedback path between the output and the first input, wherein the feedback path comprises an impedance component that forms an impedance divider with the capacitive coupling between the conductive wire and the conductive sense component; and

   a voltage measurement circuit arranged to measure a voltage at the output of the op amp, wherein the measured voltage comprises the resultant circuit.

8. The system of claim 6 or claim 7, further comprising:

   a conductive shield arranged to at least partially surround an outer perimeter of the conductive sense component, wherein the system is further configured to apply to the conductive shield a signal that is based on the reference signal.

9. The system of any of claims 2 to 8, wherein the determination circuit is further configured to:
measure the AC voltage of the conductive wire based on the measured voltage and the determined capacitive coupling between the conductive wire and the conductive sense component.

10. The system of any preceding claim, wherein the determination circuit is configured to determine the gauge of the conductive wire using an electromagnetic model of the conductive sense component and the conductive wire that represents a relationship between wire gauge and the capacitive coupling between the conductive wire and the conductive sense component.

11. The system of any preceding claim, wherein the determination circuit is configured to determine the gauge of the conductive wire using one or more stored values of capacitive coupling and an associated one or more stored values for wire gauge.

12. The system of claim 11, wherein determination of the gauge of the determination circuit is configured to determine the gauge of the conductive wire using one of:

extrapolation from the closest stored capacitive coupling value to the determined capacitive coupling between the conductive wire and the conductive sense component;
interpolation between the two closest stored capacitive coupling values to the determined capacitive coupling between the conductive wire and the conductive sense component.

13. The system of any preceding claim, further comprising:

a reference conductive sense component for positioning, when in use, in non-contacting proximity to a reference conductive wire of a known gauge so as to capacitively couple with the reference conductive wire,
wherein the determination circuit is coupled to the reference conductive sense component and is further configured to:

determine a capacitive coupling between the reference conductive wire and the reference conductive sense component;
determine a gauge of the reference conductive wire based on the determined capacitive coupling between the reference conductive wire and the reference conductive sense component;
determine a correction factor by comparing the determined gauge of the reference conductive wire and the known gauge of the reference conductive wire; and
determine the gauge of the conductive wire further based on the correction factor.

14. A method for determining wire gauge, the method comprising:

determining a capacitive coupling between a conductive wire and a conductive sense component, wherein the conductive sense component is positioned in non-contacting proximity to the conductive wire so as to capacitively couple with the conductive wire to generate an AC sensing signal at the conductive sense component, wherein the AC sensing signal is dependent on an AC voltage of the conductive wire; and
determining a gauge of the conductive wire based on the determined capacitive coupling between the conductive wire and the conductive sense component.

15. An electrical system comprising:

a conductive wire for carrying an electrical current;
a conductive sense component positioned in non-contacting proximity to the conductive wire so as to capacitively couple with the conductive wire to generate an AC sensing signal at the conductive sense component, wherein the AC sensing signal is dependent on an AC voltage of the conductive wire;
a determination circuit coupled to the conductive sense component and configured to:

determine a capacitive coupling between the conductive wire and the conductive sense component; and
determine a gauge of the conductive wire based on the determined capacitive coupling between the conductive wire and the conductive sense component.

Fig. 1

Fig. 2A

Fig. 2B

Fig. 3B

Fig. 3A

400

220

S1   Vwire

Cp

210

Vs

$C_{other}$

410

Vdiv

Voltage
measurement
420

425

Determination
circuit
430

C1   R1

Fig. 4

EP 4 682 548 A1

Fig. 5

Fig. 6B

Fig. 6A

Fig. 7A

Fig. 7B

EP 4 682 548 A1

Fig. 8

EP 4 682 548 A1

Fig. 9

EP 4 682 548 A1

Fig. 10

Fig. 11

EP 4 682 548 A1

Fig. 12

```
┌─────────────────────────┐
│                         │
│         S1310           │
│                         │
└───────────┬─────────────┘
            │
            ▼
┌─────────────────────────┐
│                         │
│         S1320           │
│                         │
└─────────────────────────┘
```

Fig. 13

Europäisches
Patentamt

European
Patent Office

Office européen
des brevets

**EUROPEAN SEARCH REPORT**

Application Number

EP 25 18 3224

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | GB 1 464 973 A (ADE CORP) 16 February 1977 (1977-02-16) | 1-9,11, 12,14,15 | INV. G01R15/16 |
| Y | * page 2, line 23 - page 4, line 2; | 10 | G01R27/26 |
| A | figures 1-3 * | 13 | G01R35/00 G01B7/06 |
| X | ----- EP 1 772 701 B1 (KOMAX HOLDING AG [CH]) 21 May 2008 (2008-05-21) | 1,2,4,6, 7,9,11, 12,14,15 | G01B7/12 |
| | * abstract * * paragraph [0011] - paragraph [0025]; figures 1-6 * | | |
| Y | ----- US 2023/236225 A1 (DUTTA PRABAL [US] ET AL) 27 July 2023 (2023-07-27) | 10 | |
| A | * abstract * * paragraph [0026] - paragraph [0042]; figure 1 * * paragraph [0044] - paragraph [0055]; figures 2-4 * * paragraph [0056] - paragraph [0113]; figures 5-12 * | 1-9, 11-15 | |
| A | ----- EP 1 920 241 B1 (JOAO R MATOS S A [PT]; INST DE SOLDADURA E QUALIDADE [PT]) 1 July 2015 (2015-07-01) * abstract * * paragraph [0056] - paragraph [0077]; figures 1-5 * | 1-15 | **TECHNICAL FIELDS SEARCHED (IPC)** G01R G01B |
| A | ----- DE 100 21 714 A1 (SIEMENS AG [DE]) 22 February 2001 (2001-02-22) * abstract * * page 6, line 7 - page 8, line 64; figures 1-8 * ----- | 1-15 | |

The present search report has been drawn up for all claims

| Place of search | Date of completion of the search | Examiner |
|---|---|---|
| Munich | 15 December 2025 | Bergado Colina, J |

EPO FORM 1503 03.82 (P04C01)

## ANNEX TO THE EUROPEAN SEARCH REPORT
## ON EUROPEAN PATENT APPLICATION NO.

EP 25 18 3224

This annex lists the patent family members relating to the patent documents cited in the above-mentioned European search report.
The members are as contained in the European Patent Office EDP file on
The European Patent Office is in no way liable for these particulars which are merely given for the purpose of information.

15-12-2025

| Patent document cited in search report | | Publication date | Patent family member(s) | | Publication date |
|---|---|---|---|---|---|
| GB 1464973 | A | 16-02-1977 | CA | 998437 A | 12-10-1976 |
| | | | DE | 2409878 A1 | 19-09-1974 |
| | | | FR | 2221710 A2 | 11-10-1974 |
| | | | GB | 1464973 A | 16-02-1977 |
| | | | JP | S49127654 A | 06-12-1974 |
| EP 1772701 | B1 | 21-05-2008 | EP | 1772701 A1 | 11-04-2007 |
| | | | EP | 1901026 A1 | 19-03-2008 |
| | | | PL | 1772701 T3 | 31-10-2008 |
| US 2023236225 | A1 | 27-07-2023 | NONE | | |
| EP 1920241 | B1 | 01-07-2015 | EP | 1920241 A1 | 14-05-2008 |
| | | | WO | 2007027117 A1 | 08-03-2007 |
| DE 10021714 | A1 | 22-02-2001 | NONE | | |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 63660935